# EUROPÄISCHE PATENTSCHRIFT

(11) **EP 1 912 913 B1**
(45) Veröffentlichungstag und Bekanntmachung des Hinweises auf die Patenterteilung: **28.12.2011**
(21) Anmeldenummer: 06762880.0
(22) Anmeldetag: 28.07.2006
(51) Int. Cl.: C03C 17/42, C03C 23/00

(54) **PHOTOKATALYTISCHES SCHICHTSYSTEM MIT HOHEM SCHALTHUB UND VERFAHREN ZU SEINER HERSTELLUNG**
PHOTOCATALYTIC LAYER SYSTEM FEATURING GREAT CONTACT TRAVEL, AND METHOD FOR THE PRODUCTION THEREOF
SYSTEME DE COUCHES PHOTOCATALYTIQUE PRESENTANT UNE COURSE DE COMMUTATION ELEVEE ET PROCEDE DE PRODUCTION DE CE SYSTEME

(30) Priorität: 29.07.2005 DE 102005035673
(43) Veröffentlichungstag der Anmeldung: 23.04.2008
(73) Patentinhaber: Fraunhofer-Gesellschaft zur Förderung der angewandten Forschung e.V., 80686 München (DE)
(72) Erfinder: VERGÖHL, Michael, 38162 Cremlingen (DE); NEUMANN, Frank, 38100 Braunschweig (DE); BIALUCH, Ingmar, 38122 Braunschweig (DE)
(74) Vertreter: Pfenning, Meinig & Partner GbR
(86) Internationale Anmeldenummer: PCT/EP2006/007498
(87) Internationale Veröffentlichungsnummer: WO 2007/014715

(56) Entgegenhaltungen:
- EP-A2- 1 160 082
- WO-A-2005/031030
- DE-A1- 10 056 242
- DE-A1- 10 226 971
- DE-A1- 10 325 768
- DE-A1- 19 521 344
- US-A1- 2001 051 273
- US-A1- 2004 224 161
- US-A1- 2005 003 146

## Beschreibung

Die vorliegende Erfindung betrifft ein photokatalytisches Schichtsystem mit hohem Schalthub, welches im unbeleuchteten Zustand hydrophob ist. Derartige photokatalytische Schichtsysteme werden insbesondere zur Beschichtung von Gläsern und Kunststoffen für Brillengläser, für Automobilscheiben oder -leuchten oder Fensterscheiben benötigt. Aber auch für Keramiken, beispielsweise Fliesen oder Sanitärartikel, für Dachziegel oder für Abdeckungen von Sensoren kann das erfindungsgemäße photokatalytische Schichtsystem verwendet werden. Weitere Anwendungsbereiche liegen im Bereich der Druckindustrie und der Analytik, insbesondere bei Biochipreadern, wo unter Einsatz des erfindungsgemäßen photokatalytischen Schichtsystems die Hydrophilie bzw. Hydrophobie von Oberflächen individuell verändert werden kann.

Als photokatalytische Materialien werden im Folgenden Materialien bezeichnet, die geeignet sind, unter oder nach Belichtung organische Substanzen zu verändern, abzubauen oder zu zerstören. Photokatalytische Materialien besitzen daher häufig einen antimikrobiellen Effekt, da sie das Wachstum von Mikroben hemmen oder verhindern.

Aus dem Stand der Technik sind photokatalytische Schichtsysteme bekannt, die im unbeleuchteten Zustand eine geringe Oberflächenenergie aufweisen. Sie sind daher dann schwer benetzbar, jedoch nicht hydrophob. Durch Beleuchtung mit Licht mit Wellenlängen kürzer als die Bandkante des als photokatalytisches Material verwendeten Halbleitermaterials kann in diesem Schichtsystem eine hohe Oberflächenenergie, d.h. gute Benetzbarkeit, mit Bezug auf polare Flüssigkeiten wie Wasser also eine Superhydrophilie mit Kontaktwinkel < 10° erreicht werden. Die Überführung vom niederenergetischen Zustand (im folgenden im Bezug auf Wasser auch als hydrophober Zustand bezeichnet) in den höherenergetischen Zustand (im folgenden unter Bezug auf Wasser auch als hydrophiler oder benetzbarer Zustand bezeichnet) erfolgt also durch die Beleuchtung mit Licht in geeigneten Wellenlängen.

Hier wie in der ganzen Anmeldung wird mit dem Begriff "Hydrophobie" grundsätzlich nicht nur die schlechte Benetzbarkeit mit polaren Flüssigkeiten wie Wasser, sondern generell auch ein Zustand geringer Oberflächenenergie bezeichnet. Hier wie in der ganzen Anmeldung wird mit dem Begriff "Hydrophilie" grundsätzlich nicht nur die gute Benetzbarkeit mit einem polaren Medium wie Wasser, sondern auch ein Zustand hoher Oberflächenenergie bezeichnet.

Von besonderem technischem und anwendungsbezogenem Interesse sind hierbei Anwendungen, die auf Basis einer im Normalzustand hydrophoben Oberfläche eine bessere Selbstreinigung ermöglichen. Technische Anwendungen liegen in den oben genannten Bereichen.

Nach dem Stand der Technik kann durch eine Strukturierung der Oberflächen in Kombination mit einer wasserabweisenden Schicht eine Erhöhung des Kontaktwinkels auf mehr als 150° erreicht werden. Dieser Effekt ist als Lotuseffekt bekannt. Allerdings haben Oberflächen mit Lotuseffekt den Nachteil einer geringen mechanischen Stabilität sowie auch mangelnder optischer Qualität. Die so strukturierten Oberflächen streuen das Licht sehr stark und sind daher im allgemeinen nicht klar transparent.

In anderen Anwendungen ist die Schaltbarkeit der photokatalytischen Schicht zwischen Superhydrophilie und Hydrophobe, allgemeiner: Eine Schaltbarkeit der Benetzbarkeit bzw. des energetischen Zustandes, von Bedeutung. Einsatzgebiete sind hierbei beispielsweise die Drucktechnik, Substrate für Pioteomicariwendungen (Biochipreader), Beschichtungen von Kondensatoren in Klimaanlagen, Anwendungen im Display- oder Automobilbereich oder auch Beschichtungen von Brillengläsern.

Die WO 2005/031030 A2 beschreibt ein Verfahren, bei dem eine Schicht eines photokatalytischen Halbleiters, wie beispielsweise TiO₂, vom benetzbaren in einen nicht-benetzbaren Zustand mittels eines Atmosphärenplasmas überführt wird.

Die Überführung aus dem Zustand geringer Oberflächenenergie (schwer benetzbar) in den Zustand hoher Oberflächenenergie (gut benetzbar) erfolgt bei derartigen Halbleitermaterialien mit photoinduzierter Hydrophilie durch Bestrahlung mit elektromagnetischer Strahlung, welche eine Energie besitzt, die mindestens der der optischen Bandlücke des Materials entspricht. Dies führt zu einer starken Erhöhung der Oberflächenenergie. Über eine derartige Photoaktivierung wird die Abnahme des Kontaktwinkels θ polarer Flüssigkeiten, wie beispielsweise Wasser, auf der Halbleiteroberfläche in den Zustand der Superhydrophilie auf bis zu θ = 0° bewirkt. Nicht benetzende Ausgangswerte liegen typischerweise im Stand der Technik im Bereich von 30° < θ < 60° für den Kontaktwinkel von Wasser.

Als schaltbare Halbleitermaterialien sind insbesondere binäre, ternäre oder quarternäre Oxide, insbesondere TiO₂, ZrO₂, SrTiO, Fe₂O₃, ZnO, SnO₂ oder CeO₂ bereits bekannt. Diese Stoffe können auch dotiert sein, um die Absorptionseigenschaften des photoinduziert schaltbaren Halbleitermaterials zu beeinflussen. Insbesondere können hierfür die Elemente Mo, Ca, B, N, S, C, F, Wo, Y, Nb, Si, Al, V, Cr, Sn, Ag, Ta, Os und weitere eingesetzt werden. Eine derartige Dotierung dient der Anpassung der Bandkanten des Halbleitermaterials und kann auch für zusätzliche Absorptionsniveaus innerhalb der Bandlücke führen.

Aufgabe der vorliegenden Erfindung ist es nun, verglichen mit den Schichtsystemen aus dem Stand der Technik ein photokatalytisches Schichtsystem mit photoinduzierter Hydrophilie zur Verfügung zu stellen, was einen wesentlich verbesserten Schalthub (Differenz der Kontaktwinkel vor und nach Beleuchtung) aufweist.

Diese Aufgabe wird durch das Schichtsystem nach Anspruch 1, das Verfahren nach Anspruch 25 sowie die Verwendungen gemäß Ansprüchen 34 und 35 gelöst. Vorteilhafte Weiterbildungen des erfindungsgemäßen Schichtsystems und des erfindungsgemäßen Verfahrens werden in den jeweiligen abhängigen Ansprüchen gegeben.

Die vorliegende Erfindung zielt auf die Erhöhung des Kontaktwinkels des Ausgangszustandes, d.h. im nichtaktivierten Dunkelzustand, ab, wobei aber trotzdem eine Superhydrophilie nach Beleuchtung erreicht werden soll. Erfindungsgemäß wird dies dadurch erzielt, dass auf die bereits bekannten photokatalytischen Schichten eine dünne, niederenergetische (bzw. schwer benetzbare oder hydrophobe/wasserabweisende) Schicht aufgebracht wird. Als solche Schichten können sämtliche diamantartigen Kohlenstoffschichten verwendet werden, die auch als DLC-Schichten, a-C:H-Schichten bzw. amorphe Kohlenstoffschichten bezeichnet werden. Derartige DLC-Schichten können durch Dotierung hydrophob ausgestattet werden. Mögliche Dotierstoffe sind hierbei Silizium oder Fluor. Eine derartige siliziumdotierte DLC-Schicht ist als SICON-Schicht bekannt. Diese wird auch als a-C:H:Si:O-Schicht bezeichnet. Es ist jedoch auch Polytetrafluorethylen (PTFE) als Schichtmaterial geeignet.

Die Dicke der photokatalytischen Schicht beträgt vorteilhafterweise zwischen 1 nm und 5 mm. Die Dicke der photokatalytischen beträgt vorteilhafterweise < 500 nm, wobei eine Dicke im Bereich um 40 nm besonders vorteilhaft ist. Durch Einstellung der Dicke der DLC-Schicht kann ein Optimum zwischen der Superhydrophilie im aktivierten sowie der Hydrophobie im nichtaktivierten Zustand erreicht werden.

Das erfindungsgemäße Schichtsystem wird dabei so ausgebildet, dass auf dem Substrat die erste Schicht und die zweite Schicht (vgl. Hauptanspruch) ein erstes Teilschichtsystem bilden, auf dem zumindest ein weiteres, zweites Teilschichtsystem, das eine der ersten Schicht des ersten Teilschichtsystems entsprechende erste Schicht und darauf angeordnet eine der zweiten Schicht des ersten Teilschichtsystems entsprechende zweite Schicht aufweist, so angeordnet ist, dass die erste Schicht des zweiten Teilschichtsystems auf der zweiten Schicht des darunter liegenden ersten Teilschichtsystems angeordnet ist.

Insbesondere kann das erfindungsgemäße Schichtsystem so ausgebildet werden, dass im nichtaktivierten Zustand die Oberfläche des Schichtsystems einen Kontaktwinkel für polare Flüssigkeiten, insbesondere für Wasser, von ≥ 90°, vorteilhafterweise ≥ 120°, vorteilhafterweise ≥ 150° aufweist. Vorteilhafterweise wird das Schichtsystem dabei so ausgebildet, dass im aktivierten Zustand die Oberfläche des Schichtsystems einen Kontaktwinkel für polare Flüssigkeiten, insbesondere für Wasser, von ≥ 10° aufweist. Das erfindungsgemäße Schichtsystem kann so ausgebildet werden, dass es zwischen einem nichtaktivierten Zustand und einem aktivierten Zustand umschaltbar ist, wobei im nichtaktivierten Zustand die Oberfläche des Schichtsystems einen Kontaktwinkel ≥ 90° für polare Flüssigkeiten, insbesondere für Wasser, vorteilhafterweise ≥ 120°, vorteilhafterweise ≥ 150° aufweist und im aktivierten Zustand die Oberfläche des Schichtsystems einen Kontaktwinkel für polare Flüssigkeiten, insbesondere für Wasser, ≥ 10° aufweist.

Überraschenderweise hat sich nun herausgestellt, dass durch eine derartige DLC-Schicht die Nicht-Benetzbarkeit bzw. Hydrophobie des Schichtsystems erheblich verbessert wird, insoweit nunmehr Kontaktwinkel > 90° (also Hydrophobie im eigentlichen Sinne), vorteilharterweise > 120°, vorteilhafterweise > 150° im nicht-aktivierten Zustand erreicht werden können. Erstaunlicherweise hat sich jedoch herausgestellt, dass durch die hydrophobe DLC-Schicht nicht verhindert wird, dass die Oberfläche des gesamten Schichtsystems durch Belichtung in einen superhydrophilen Zustand' gebracht werden kann. Offensichtlich bewirkt die veränderte Hydrophilie der photokatalytischen Schicht, dass auch die nach außen wirkende Oberfläche der zweiten Schicht benetzbar bzw. hydrophil wird.

Weiterhin verhindert die zweite Schicht erstaunlicherweise nicht, dass das gesamte Schichtsystem an seiner Oberfläche unter Beleuchtung photokatalytisch wirkt.

Das erfindungsgemäße Schichtsystem ist insbesondere reflexmindernd bzw. reflexarm, so dass es sich beispielsweise auch zur Beschichtung von Brillengläsern oder Sensorabdeckungen eignet.

Durch die hohe Härte von DLC bzw. SICON wird zudem eine Verbesserung der Kratzbeständigkeit erreicht, welche bei anderen Ansätzen, wie z.B. bei einem Polysiloxan-Lack wie beim hydrophoben Produkt "LOTUTEC" von Zeiss nicht möglich ist. Durch den geringeren Brechungsindex von DLC bzw. SICON wird zudem eine Reduzierung der Reflexion gegenüber hydrophilen, meist hochbrechenden Oberflächen (z.B. TiO₂) erreicht, so dass z.B. auch eine reflexmindernde Beschichtung möglich ist.

Das hydrophilierbare Material kann vorzugsweise in Form eines dünnen Films mit einer Dicke von nur wenigen Nanometern bis hin zu Dickfilmen im Dickenbereich von mehreren Millimetern auf alle Arten von Bauteilen aufgebracht sein. Der bevorzugte Dickenbereich liegt unter 1000 nm, der besonders bevorzugte Dickenbereich liegt zwischen 10 und 500 nm. Als Beschichtungstechniken können neben nasschemischen (Sol-Gel-Verfahren oder Lackierverrahren), und CVD- ("Chemical Vapor Deposition") Verfahren insbesondere auch PVD- ("Physical Vapor Deposition") Verfahren eingesetzt werden. Die CVD- und PVD-Verfahren können auch unterstützt sein durch ein zusätzliches Plasma (PECVD, plasma enhanced CVD). Bei den PVD-Verfahren können Magnetronsputterverfahren, Ionenstrahlsputterverfahren oder ionen- oder plasmaunterstützte Aufdampfverfahren eingesetzt werden.

Das hydrophobe Material kann ebenfalls vorzugsweise in Form eines dünnen Films mit einer Dicke von ca. 1 nm bis hin zu etwa 200 nm auf die hydrophilierbare Schicht aufgebracht sein. Der bevorzugte Dickenbereich liegt zwischen 3 und 40 nm, der besonders bevorzugte Dickenbereich liegt zwischen 3 und 20 nm. Als Beschichtungstechniken können neben nasschemischen (Sol-Gel-Verfahren, Lackierverfahren) vor allem plasmaunterstützte CVD- ("Chemical Vapor Deposition") Verfahren (PECVD) eingesetzt werden. Nicht ausgeschlossen ist aber auch ein PVD- ("Physical Vapor Deposition") Verfahren. Bei den PVD-Verfahren können vorzugsweise Magnetronsputterverfahren oder Ionenstrahlsputtern oder ionen- oder plasmaunterstützte Aufdampfverfahren eingesetzt werden.

Wird zwischen das Substrat und die photokatalytische Schicht und/oder die photokatalytische und die zweite Schicht eine weitere Schicht, z.B. eine Haftvermittlungs- und/oder Barriereschicht eingezogen, so wird die Verwendung weiterer Materialien ermöglicht oder verbessert. Mit einer Barriereschicht zwischen Substrat und photokatalytischer Schicht kann bei einem Glassubstrat die Na-Diffusion in die photokatalytische Schicht oder bei einem Kunststoffsubstrat dessen Degradation durch Eindiffusion von Stoffen aus den darüberliegenden Schichten verhindert werden. Diese weiteren Schichten können ebenfalls mit den bereits für die Aufbringung der ersten oder zweiten Schicht genannten Verfahren aufgebracht werden.

Gemäß der Erfindung weist das Schichtsystem mehrere photokatalytische und hydrophobe Schichten auf. In diesem Falle sind auf dem Substrat abwechselnd eine photokatalytische Schicht und auf dieser eine hydrophobe Schicht angeordnet. Dabei ist die unterste, an das Substrat grenzende Schicht vorzugsweise eine photokatalytische Schicht. Auf dieser befindet sich dann eine hydrophobe Schicht, auf welcher wiederum eine photokatalytische Schicht angeordnet ist, auf welcher wiederum eine hydrophobe Schicht liegt. Definiert man das System aus einer photokatalytischen Schicht und einer hydrophoben Schicht als ein Teilschichtsystem, so können erfindungsgemäß 1 bis 1000 Teilschichtsysteme aufeinander angeordnet werden. Vorzugsweise hat das Schichtsystem 10 bis 100 Teilschichtsysteme.

Für Materialien, Eigenschaften, Anordnungen, Abmessungen und Zwischenschichten der Teilschichtsysteme gilt das oben Ausgeführte. Besonders bevorzugt ist für die einzelnen Schichten hier jedoch eine Dicke zwischen 2 nm und 100 nm.

Der Vorteil eines solchen Vielschichtsystems ist eine besonders hohe Verschleißbeständigkeit.

Darüber hinaus können die mit einer der oben aufgeführten Beschichtungsmethoden hergestellten Dünnschichten in ihrer Photoaktivierbarkeit auch optimiert werden, wenn sie einem nachträglichen Temperschritt unterworfen werden, um Kristallisationsvorgänge im Filmvolumen hervorzurufen. Dieser Temperschritt kann in verschiedenen Atmosphären erfolgen (Luft, O₂, N₂, ...). Die Temperatur für den Temperschritt sollte im Bereich von 200 bis 1000 °C liegen (je nach Aufweichpunkt des Substrats). Bevorzugt sollte sie im Bereich von 250 bis 800 °C liegen. Besonders bevorzugt ist der Temperaturbereich von 300 bis 600 °C. Die Dauer des Temperschrittes bei der Temperdauer sollte mindestens 1 min betragen. Bevorzugt ist eine Temperdauer von mindestens 1 h zu wählen, besonders bevorzugt wäre eine Temperdauer von mehr als 3 h.

Als Substrat sind alle Unterlagen denkbar, die eine gute Haftung des Dünnfilms gewährleisten, beispielsweise Glas, Metall, Keramik, Kunststoffe, Papier oder Leder. Gegebenenfalls muss die Haftung durch einen Haftvermittler zwischen Schicht und Substrat erhöht werden, welche auch eine den Effekt zerstörende Ionendiffusion in die Schicht verhindern kann. Alternativ kann zur Haftungsverbesserung auch eine PlasmaVorbehandlung (Sputterätzen, Beglimmen, RF-Plasmabehandlung etc.) erfolgen, wobei allerdings kein Schutz gegen Na-Diffusion gewährleistet ist. Erfindungsgemäß erfolgt die Erhöhung der Oberflächenenergie der erfindungsgemäßen Schicht durch die Beleuchtung,mit elektromagnetischer Strahlung. Die elektromagnetische Strahlung muss in ihrem Energiespektrum Anteile besitzen, die mindestens so groß sind wie die Bandlücke des aktivierbaren Halbleitermaterials. Als Lichtquellen können hierfür z.B. Fluoreszenzlampen eingesetzt werden. Bevorzugt können aber auch Laserquellen eingesetzt werden. Besonders bevorzugt können zur Beleuchtung Quecksilber- oder Xenon-Entladungslampen oder auch Eximerlampen eingesetzt werden. Gegebenenfalls können aber auch, je nach Bandlücke des verwendeten Materials, Lampen eingesetzt werden, die zu wesentlichen Anteilen sichtbares Licht ohne oder mit nur geringen UV-Anteilen emittieren, wie beispielsweise Halogen- oder Glühlampen. Aber auch Sonnenlicht kann die Aktivierung hervorrufen. Für die Bestrahlungsstärke der Strahlung reichen wenige µW/cm² aus. Zur Erzielung schnellerer Aktivierungszeiten kann bevorzugt, aber auch eine höhere Bestrahlungsstärke verwendet werden (> 1 W/cm²). Die angegebenen Bestrahlungsstärken beziehen sich auf den Teil des Spektrums der verwendeten elektromagnetischen Strahlung, welcher mindestens die Energie hat, die der optischen Bandlücke des aktivierten Materials entspricht.

Im Folgenden werden einige Ausführungsbeispiele erfindungsgemäßer Schichtsysteme gegeben. Es zeigen
- Figur 1: den Aufbau eines Schichtsystems;
- Figur 2: den Aufbau eines weiteren Schichtsystems;
- Figur 3 bis 5: Ergebnisse mit erfindungsgemäßen Schichtsystemen (Figur 4).
- Figur 6: ein erfindungsgemäßes Schichtsystem mit einer Vielzahl alternierender Lagen.

Bei den folgenden Ausführungsbeispielen wird jeweils eine dünne transparente TiO₂-Schicht durch reaktives Mittelfrequenzmagnetronsputtern auf einem Glassubstrat abgeschieden. Die Dicke der TiO₂-Schicht betrug 400 nm. Darüber wurde eine dünne SICON-Schicht mit einer Dicke von 10 nm abgeschieden.

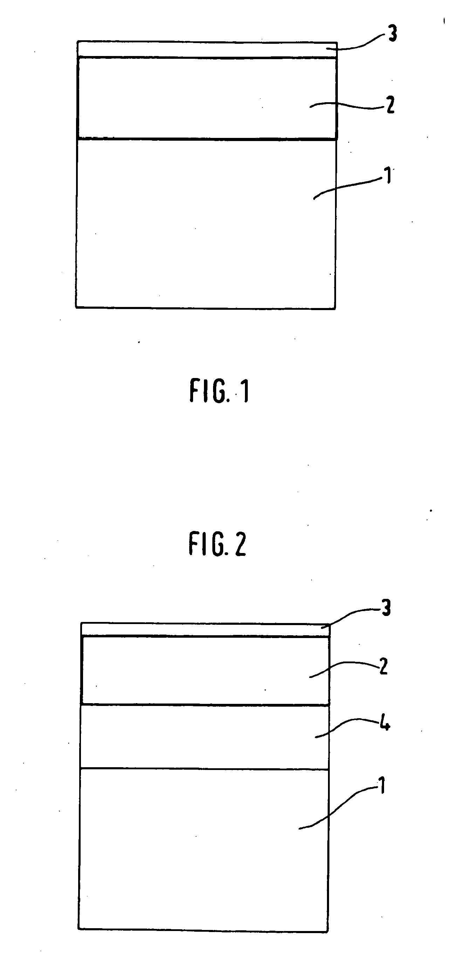

Figur 1 zeigt nun den Aufbau einer Schicht mit einem Glassubstrat 1, einer auf der Oberfläche des Glassubstrates angeordneten TiO₂-Schicht 2 sowie einer darauf angeordneten SICON-Schicht 3. In Figur 2 ist eine weitere Variante dargestellt, bei der zusätzlich zu den oben genannten Schichten 1 bis 3 zwischen dem Substrat 1 und der TiO₂-Schicht 2 eine weitere SiO₂-Schicht angeordnet ist. Diese Schicht 4 dient als Haftvermittlungsschicht sowie als Diffusionsbarriere. In der Figur 2 wurde als Substrat 1 nicht wie in Figur 1 Glas, sondern ein Kunststoffsubstrat 1 verwendet.

Bei den gemäß Figur 1 hergestellten Schichten wurde im unaktivierten, d.h. im nicht beleuchteten Probenzustand, ein Randwinkel für deionisiertes Wasser von 113° bestimmt. Die Bestimmung des Kontaktwinkels zu Wasser wurde dabei mit einem Randwinkelmesser der Firma Data Physics im dynamischen Modus durchgeführt.

Die Aktivierung der Probe erfolgte durch Beleuchtung mit elektromagnetischer Strahlung, welche Spektralanteile besitzt, deren Energie größer als die Bandlücke des beleuchteten Titandioxids ist. Zur Beleuchtung wurde im vorliegenden Fall eine UV-Lichtquelle mit einer Wellenlänge von 366 nm eingesetzt. Die mittlere spektrale Strahlungsflussdichte am Substrat betrug 1 W/m². Die Dauer der Bestrahlung betrug 24 h, wobei zu bemerken ist, dass hierdurch eine deutliche Überladung erfolgte. Nach der 24h-Beleuchtung war die Probe superhydrophil, d.h. der Wasserkontaktwinkel lag unter 10°. Es ist zu bemerken, dass auch nach kürzerer Beleuchtung (1 h UV-Licht) der superhydrophile Zustand erreicht wurde.

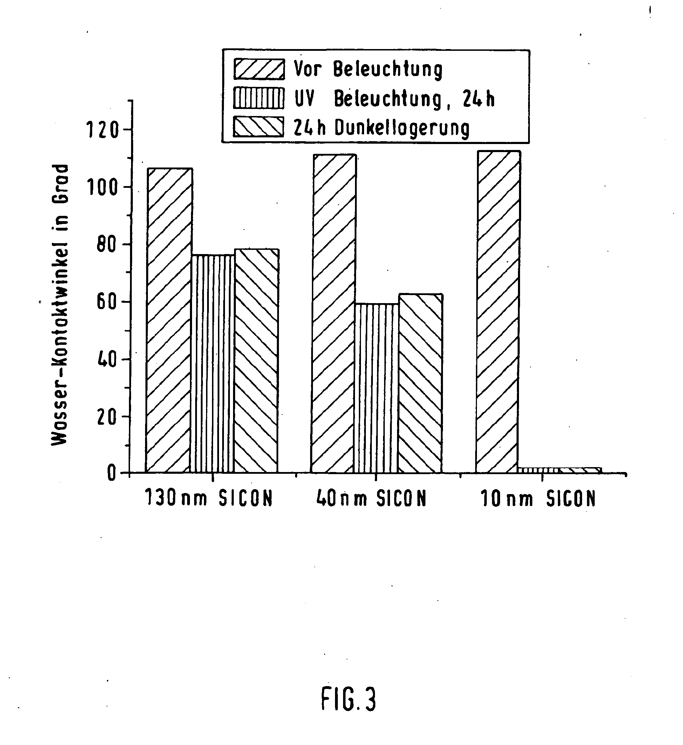

In Figur 3 sind die Werte des Kontaktwinkels vor der Beleuchtung, direkt nach der Beleuchtung sowie nach an die Beleuchtung anschließenden 24 h Dunkellagerung gezeigt. Hier wurden drei verschiedene Proben mit SICON-Schichten mit Dicken von 10 nm, 40 nm und 130 nm gemessen. Bei der 10 nm dicken SICON-Schicht blieb die Superhydrophilie auch nach 24 h Dunkellagerung erhalten, während vor der Beleuchtung die Probe hydrophob ist. Dieses Verhalten ist im Vergleich zu herkömmlichen, hydrophilen TiO₂-Schichten ebenfalls ungewöhnlich; im Allgemeinen lässt die Superhydrophilie bereits nach wenigen Stunden nach, so dass sich der Kontaktwinkel allmählich erhöht.

Der hydrophobe Zustand kann beispielsweise durch eine längere Dunkellagerung, besser jedoch über eine Wärmebehandlung, durch eine nasschemische Behandlung wie beispielsweise ein Kyrolinbad oder auch in einem atmosphärischen Plasma wiederhergestellt werden. Damit kann zwischen dem hydrophoben und dem hydrophilen Zustand hin und her geschaltet werden.

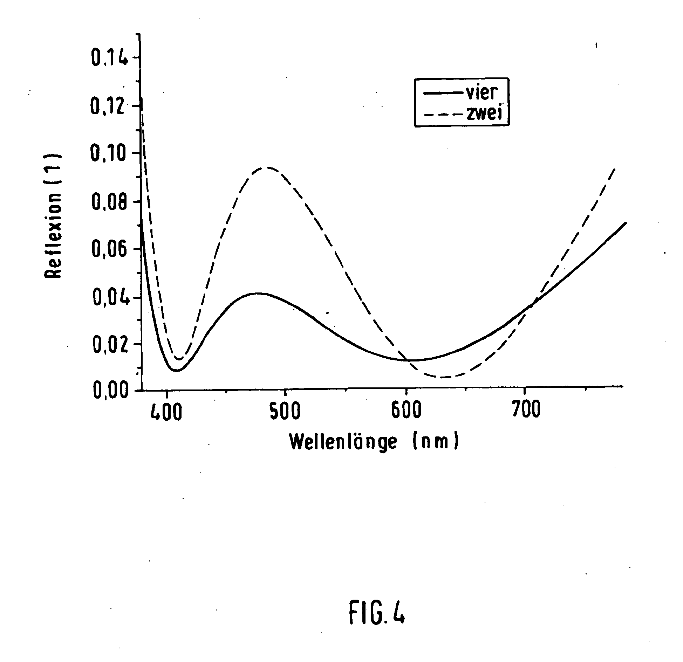

In Figur 4 ist das Reflexionsspektrum einer 4-fach Multischicht (durchgezogene Linie) bestehend aus jeweils zwei TiO₂- und zwei SICON-Schichten dargestellt (erfindungsgemäß). Die Schichtfolge ist: Glas - TiO₂ (12 nm) - SICON (44 nm) - TiO₂ (20 um) - SICON (90 nm). Hiermit wird gegenüber dem Glassubstrat im Wellenlängenbereich 400 bis 680 nm eine deutliche Entspiegelung erreicht. Das Glassubstrat reflektiert selber das Licht zu etwa 4,5 %. Ebenfalls dargestellt ist eine Schicht bestehend aus zwei Einzelschichten (gestrichelte Linie) mit der Abfolge Glas - 93 nm TiO₂ - 72 nm SiCON.

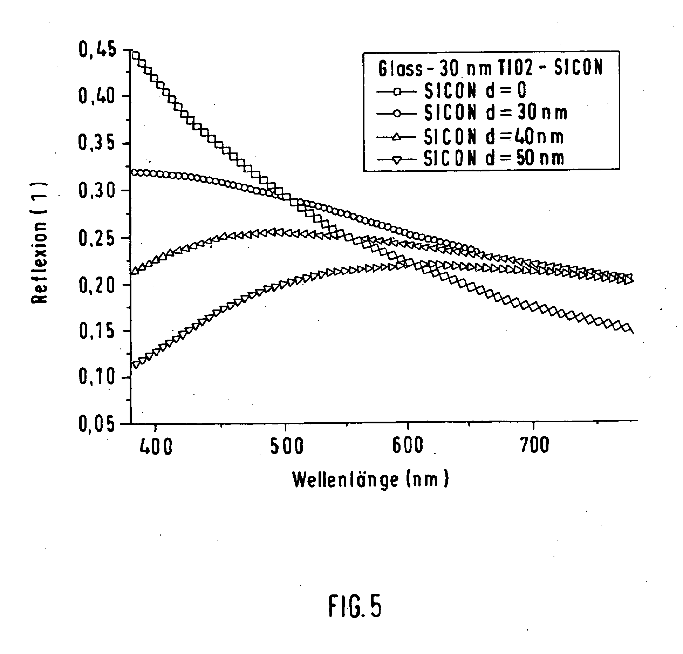

In Figur 5 sind verschiedene Reflexionsspektren dargestellt. Die verwendete Probe weist auf einem Glassubstrat eine 30 nm dicke TiO₂-Schicht auf, auf der SICON-Schichten mit unterschiedlichen Dicken (0, 30, 40 oder 50 nm) aufgebaut sind. Die Reflexion wird offensichtlich mit zunehmender SICON-Dicke beginnend vom kurzwelligen Spektralbereich gegenüber der reinen TiO₂-Schicht (SICON d = 0 nm) reduziert. Bereits bei einer Dicke der SICON-Schicht von etwa 30 nm ist dieser Effekt visuell sichtbar. Darüber hinaus bewirkt die SICON-Deckschicht eine deutliche Verbesserung der Farbneutralität auch bei sehr dünnen Simon-Schichten gegenüber der einfachen TiO₂-Schicht.

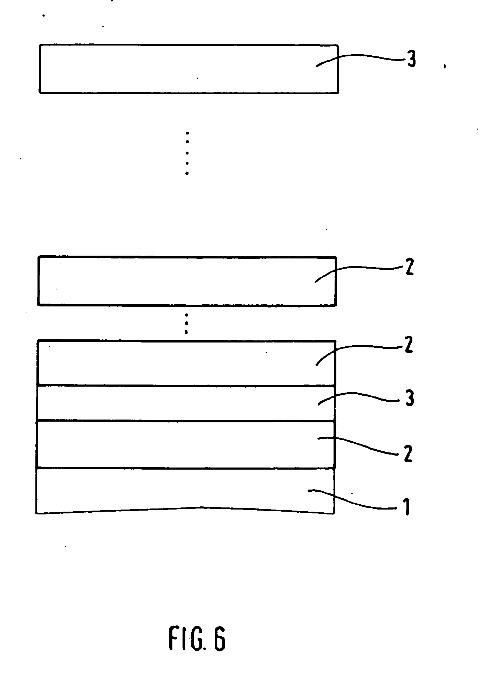

Figur 6 zeigt ein erfindungsgemäßes Schichtsystem mit einer Vielzahl von abwechselnd angeordneten photokatalytischen Schichten 2 und hydrophoben Schichten 3. Zuunterst ist in dem Schichtsystem ein Substrat 1 angeordnet, welches beispielsweise Glas oder Polymere aufweisen kann. Auf diesem Substrat 1 ist dann zunächst eine photokatalytische Schicht 2 beispielsweise aus TiO₂ angeordnet, auf welcher eine hydrophobe Schicht 3, beispielsweise aus SICON, angeordnet ist. Dieser SICON-Schicht 3 folgt wiederum eine Titandioxidschicht 2, auf welcher wiederum eine photokatalytische Schicht 3 angeordnet ist. Die Dicken der Einzelschichten betragen jeweils etwa 2 bis 5 nm. Um eine ausreichende Verschleißfestigkeit zu erreichen, sollte die Gesamtdicke des Schichtsystems auf Polymeroberflächen zwischen 500 und 5000 nm betragen. Auf Glas reichen einige 100 nm bis 2000 nm aus.

## Patentansprüche

1. Photokatalytisches Schichtsystem mit einem Substrat und einer auf dem Substrat angeordneten ersten Schicht, die ein photokatalytisches Material mit photoinduzierbarer hoher Oberflächenenergie, guter Benetzbarkeit bzw. Hydrophilie enthält oder daraus besteht, wobei auf der ersten Schicht eine zweite Schicht mit einer der ersten Schicht abgewandten, schlecht benetzbaren bzw. hydrophoben Oberfläche angeordnet ist
**dadurch gekennzeichnet, dass**
auf dem Substrat die erste Schicht und die zweite Schicht ein erstes Teilschichtsystem bilden, auf welchem zumindest ein weiteres, zweites Teilschichtsystem, welches eine der ersten Schicht des ersten Teilschichtsystems entsprechende erste Schicht und darauf angeordnet eine der zweiten Schicht des ersten Teilschichtsystems entsprechende zweite Schicht aufweist, so angeordnet ist, dass die erste Schicht des zweiten Teilschichtsystems auf der zweiten Schicht des darunter liegenden ersten Teilschichtsystems angeordnet ist.

2. Schichtsystem nach dem vorhergehenden Anspruch, **dadurch gekennzeichnet, dass** das Material mit photoinduzierbarer Hydrophilie ein Halbleitermaterial enthält oder daraus besteht.

3. Schichtsystem nach einem der beiden vorhergehenden Ansprüche, **dadurch gekennzeichnet, dass** das Material mit photoinduzierbarer Hydrophilie ein binäres, ternäres oder quaternäres Oxid enthält oder daraus besteht.

4. Schichtsystem nach dem vorhergehenden Anspruch, **dadurch gekennzeichnet, dass** das Material mit photoinduzierbarer Hydrophilie TiOₓ, ZnOₓ, WOₓ, SrTiOₓ, ZrOₓ, FeOₓ, NbOₓ, HfOₓ, SnOₓ, CeOₓ, AlOₓ, SiOₓ, BiOₓ oder eine Mischung hiervon enthält oder daraus besteht.

5. Schichtsystem nach dem vorhergehenden Anspruch, **dadurch gekennzeichnet, dass** das Material mit photoinduzierbarer Hydrophilie TiO₂, SrTiO, ZrO₂, Fe₂O₃, SnO₂, ZnO oder eine Mischung hiervon enthält oder daraus besteht.

6. Schichtsystem nach einem der vorhergehenden Ansprüche, **dadurch gekennzeichnet, dass** das Material mit photoinduzierbarer Hydrophilie mit anderen Materialien, insbesondere Übergangsmetallen und/oder Mo, Ca, S, C, F, Wo, B, N, Y, Nb, Si, Al, V, Cr, Sn, Ag, Ta, C, Pt, P, Cu und/oder Os dotiert ist.

7. Schichtsystem nach einem der vorhergehenden Ansprüche, **dadurch gekennzeichnet, dass** die erste Schicht eine Dicke ≥ 1 nm, vorteilhafterweise ≥ 10 nm aufweist.

8. Schichtsystem nach einem der vorhergehenden Ansprüche, **dadurch gekennzeichnet, dass** die erste Schicht eine Dicke ≤ 5 mm, vorteilhafterweise ≤ 1000 nm, vorteilhafterweise ≤500 nm aufweist.

9. Schichtsystem nach einem der vorhergehenden Ansprüche, **dadurch gekennzeichnet, dass** die zweite Schicht eine PTFE-Schicht ist.

10. Schichtsystem nach einem der Ansprüche 1 bis 8, **dadurch gekennzeichnet, dass** die zweite Schicht eine aus diamantartigem Kohlenstoff (DLC) bestehende oder diese enthaltende Schicht ist.

11. Schichtsystem nach den Ansprüchen 1 bis 8 oder 10, **dadurch gekennzeichnet, dass** die zweite Schicht eine a-C:H-Schicht ist.

12. Schichtsystem nach einem der beiden vorhergehenden Ansprüche, **dadurch gekennzeichnet, dass** die zweite DLC-Schicht durch Dotierung mit einer hydrophoben Oberfläche versehen ist.

13. Schichtsystem nach einem der drei vorhergehenden Ansprüche, **dadurch gekennzeichnet, dass** die zweite Schicht mit Si, O und/oder F dotiert ist.

14. Schichtsystem nach dem vorhergehenden Anspruch, **dadurch gekennzeichnet, dass** die zweite Schicht eine a-C:H:Si:O-Schicht, eine a-C:H:Si oder eine a-C:H:F-Schicht ist.

15. Schichtsystem nach einem der vorhergehenden Ansprüche, **dadurch gekennzeichnet, dass** die zweite Schicht eine Dicke ≥ 1 nm, vorteilhafterweise ≥ 3 nm aufweist.

16. Schichtsystem nach einem der vorhergehenden Ansprüche, **dadurch gekennzeichnet, dass** die zweite Schicht eine Dicke ≤ 200 nm, vorteilhafterweise ≤ 40 nm, vorteilhafterweise ≤ 20 nm aufweist.

17. Schichtsystem nach einem der vorhergehenden Ansprüche, **dadurch gekennzeichnet, dass** das Substrat Glas, Metal, Keramik, Kunststoff, Papier und/oder Leder zumindest an seiner Oberfläche enthält oder daraus besteht.

18. Schichtsystem nach einem der vorhergehenden Ansprüche, **dadurch gekennzeichnet, dass** auf dem Schichtsystem zwischen einem und 1000, vorzugsweise zwischen 10 und 100 , weitere Teilschichtsysteme, welche jeweils eine der ersten Schicht des ersten Teilschichtsystems entsprechende erste Schicht und darauf angeordnet eine der zweiten Schicht des ersten Teilschichtsystems entsprechende zweite Schicht aufweisen, so angeordnet sind, dass die erste Schicht eines Teilschichtsystems auf der zweiten Schicht des darunter liegenden Teilschichtsystems liegt.

19. Schichtsystem nach einem der vorhergehenden Ansprüche, **dadurch gekennzeichnet, dass** die ersten Schichten und/oder die zweiten Schichten jeweils eine Dicke ≤ 2 nm aufweisen.

20. Schichtsystem nach einem der vorhergehenden Ansprüche, **dadurch gekennzeichnet, dass** die ersten Schichten und/oder die zweiten Schichten jeweils eine Dicke ≤ 100 nm aufweisen.

21. Schichtsystem nach einem der vorhergehenden Ansprüche, **dadurch gekennzeichnet, dass** die ersten Schichten eines Teils oder aller Teilschichtsysteme wie die erste Schicht des ersten Teilschichtsystems aufgebaut sind und/oder dass die zweiten Schichten eines Teils oder aller Teilschichtsysteme wie die zweite Schicht des ersten Teilschichtsystems aufgebaut sind.

22. Schichtsystem nach einem der vorhergehenden Ansprüche, **dadurch gekennzeichnet, dass** zwischen dem Substrat und der ersten Schicht und/oder zwischen der ersten Schicht und der zweiten Schicht zumindest eines Teilschichtsystems bzw. des Schichtsystems und/oder gegebenenfalls zwischen zumindest zwei Teilschichtsystemen mindestens eine weitere Schicht angeordnet ist.

23. Schichtsystem nach dem vorhergehenden Anspruch, **dadurch gekennzeichnet, dass** die weitere Schicht eine Haftvermittlungsschicht und/oder eine Diffusionsbarriere ist.

24. Schichtsystem nach einem der vorhergehenden Ansprüche, **dadurch gekennzeichnet, dass** auf der zweiten Schicht und/oder auf der obersten Schicht mindestens eine weitere Schutzschicht gegen chemische und/oder mechanische Angriffe oder Beschädigungen angeordnet ist.

25. Verfahren zur Herstellung eines Schichtsystems nach einem der vorhergehenden Ansprüche, wobei auf ein Substrat eine erste Schicht, die ein photokatalytisches Material mit photoinduzierbarer Hydrophilie enthält oder daraus besteht, und auf die erste Schicht eine zweite, aus diamantartigem Kohlenstoff (DLC) bestehende oder diesen enthaltende Schicht mit einer der ersten Schicht abgewandten hydrophoben Oberfläche aufgebracht wird
**dadurch gekennzeichnet, dass**
auf die zweite Schicht zumindest einmal eine weitere, der ersten Schicht entsprechende oder wie die erste Schicht aufgebaute Schicht und auf diese eine weitere, der zweiten Schicht entsprechende oder wie die zweite Schicht aufgebaute Schicht aufgebracht wird.

26. Verfahren nach dem vorhergehenden Anspruch, **dadurch gekennzeichnet, dass** die erste Schicht mittels PVD, Ionenstrahlsputtern, Magnetronsputtern, CVD, PECVD, Bedampfen, Lackieren und/oder Sol-Gel-Verfahren aufgebracht wird.

27. Verfahren nach einem der beiden vorhergehenden Ansprüche, **dadurch gekennzeichnet, dass** die zweite Schicht mittels PVD, Ionenstrahlsputtern, Magnetronsputtern, CVD, PECVD, Bedampfen, Lackieren und/oder Sol-Gel-Verfahren aufgebracht wird.

28. Verfahren nach einem der Ansprüche 25 bis 27, **dadurch gekennzeichnet, dass** zwischen das Substrat und die erste Schicht und/oder zwischen die erste Schicht und die zweite Schicht eine weitere Schicht aufgebracht wird.

29. Verfahren nach dem vorhergehenden Anspruch, **dadurch gekennzeichnet, dass** als weitere Schicht eine Haftvermittlungs- und/oder Diffusionsbarrierenschicht aufgebracht wird.

30. Verfahren nach einem der beiden vorhergehenden Ansprüche, **dadurch gekennzeichnet, dass** die weitere Schicht mittels PVD, Ionenstrahlsputtern, Magnetronsputtern, CVD, PECVD, Bedampfen, Lackieren und/oder Sol-Gel-Verfahren aufgebracht wird.

31. Verfahren nach einem der Ansprüche 25 bis 30, **dadurch gekennzeichnet, dass** das Schichtsystem getempert wird.

32. Verfahren nach dem vorhergehenden Anspruch, **dadurch gekennzeichnet, dass** das Schichtsystem bei einer Temperatur zwischen 200°C und 1000°C, vorzugsweise zwischen 250°C und 800°C, vorzugsweise zwischen 300°C und 600°C getempert wird.

33. Verfahren nach einem der beiden vorhergehenden Ansprüche, **dadurch gekennzeichnet, dass** das Schichtsystem ≥ 1 min, vorzugsweise ≥ 1 Stunde, vorzugsweise ≥ 3 Stunden getempert wird.

34. Verwendung eines Schichtsystems und/oder eines Verfahrens nach einem der vorhergehenden Ansprüche zur Beschichtung von Gläsern, Keramik, Steingut, Ziegel und Kunststoffen als Substrat, von Brillengläsern, Automobilscheiben, Automobilbeleuchtung, Fensterscheiben, Fliesen, Sanitärartikel und/oder Dachziegeln.

35. Verwendung eines Schichtsystems und/oder eines Verfahrens nach einem der Ansprüche 1 bis 33 in der Drucktechnik, in der Forschung und Analytik, insbesondere in Biochipreadern, zur Beschichtung von Kondensatoren in Klimaanlagen und/oder zur Beschichtung von Anzeigeelementen und/oder Sensorabdeckungen.

## Claims

1. A photocatalytic layer system having a substrate and a first layer which is arranged on the substrate and contains or comprises a photocatalytic material having photo-inducible high surface energy and good wettability or hydrophilicity, wherein a there is arranged on the first layer a second layer having a surface which has poor wettability or is hydrophobic and is remote from the first layer, **characterised in that**, on the substrate, the first layer and the second layer form a first partial layer system on which there is arranged at least a further, second partial layer system, which has a first layer corresponding to the first layer of the first partial layer system and, arranged thereon, a second layer corresponding to the second layer of the first partial layer system, such that the first layer of the second partial layer system is arranged on the second layer of the first partial layer system lying below it.

2. A layer system according to the preceding claim, **characterised in that** the material having photo-inducible hydrophilicity contains or comprises a semiconductor material.

3. A layer system according to either of the two preceding claims, **characterised in that** the material having photo-inducible hydrophilicity contains or comprises a binary, ternary or quaternary oxide.

4. A layer system according to the preceding claim, **characterised in that** the material having photo-inducible hydrophilicity contains or comprises TiOₓ, ZnOₓ, WOₓ, SrTiOₓ, ZrOₓ, FeOₓ, NbOₓ, HfOₓ, SnOₓ, CeOₓ, AlOₓ, SiOₓ, BiOₓ or a mixture thereof.

5. A layer system according to the preceding claim, **characterised in that** the material having photo-inducible hydrophilicity contains or comprises TiO₂, SrTiO, ZrO₂, Fe₂O₃, SnO₂, ZnO or a mixture thereof.

6. A layer system according to one of the preceding claims, **characterised in that** the material having photo-inducible hydrophilicity is doped with other materials, in particular transition metals and/or Mo, Ca, S, C, F, Wo, B, N, Y, Nb, Si, Al, V, Cr, Sn, Ag, Ta, C, Pt, P, Cu and/or Os.

7. A layer system according to one of the preceding claims, **characterised in that** the first layer has a thickness ≥ 1 nm, advantageously ≥ 10 nm.

8. A layer system according to one of the preceding claims, **characterised in that** the first layer has a thickness ≤ 5 mm, advantageously ≤ 1000 nm, advantageously ≤ 500 nm.

9. A layer system according to one of the preceding claims, **characterised in that** the second layer is a PTFE layer.

10. A layer system according to one of Claims 1 to 8, **characterised in that** the second layer is a layer comprising or containing diamond-like carbon (DLC).

11. A layer system according to one of Claims 1 to 8 or 10, **characterised in that** the second layer is an a-C:H layer.

12. A layer system according to either of the two preceding claims, **characterised in that** the second DLC layer is provided with a hydrophobic surface by doping.

13. A layer system according to one of the three preceding claims, **characterised in that** the second layer is doped with Si, O and/or F.

14. A layer system according to the preceding claim, **characterised in that** the second layer is an a-C:H:Si:O layer, an a-C:H:Si or an a-C:H:F layer.

15. A layer system according to one of the preceding claims, **characterised in that** the second layer has a thickness ≥ 1 nm, advantageously ≥ 3 nm.

16. A layer system according to one of the preceding claims, **characterised in that** the second layer has a thickness ≤ 200 nm, advantageously ≤ 40 nm, advantageously ≤ 20 nm.

17. A layer system according to one of the preceding claims, **characterised in that** the substrate contains or comprises at least on its surface glass, metal, ceramic, plastics, paper and/or leather.

18. A layer system according to one of the preceding claims, **characterised in that** there are arranged on the layer system between one and 1000, preferably between 10 and 100, further partial layer systems which each have a first layer corresponding to the first layer of the first partial layer system and, arranged thereon, a second layer corresponding to the second layer of the first partial layer system, such that the first layer of a partial layer system lies on the second layer of the partial layer system lying below it.

19. A layer system according to one of the preceding claims, **characterised in that** the first layers and/or the second layers each have a thickness ≥ 2 nm.

20. A layer system according to one of the preceding claims, **characterised in that** the first layers and/or the second layers each have a thickness ≤ 100 nm.

21. A layer system according to one of the preceding claims, **characterised in that** the first layers of some or all of the partial layer systems have a structure like that of the first layer of the first partial layer system, and/or **in that** the second layers of some or all of the partial layer systems have a structure like that of the second layer of the first partial layer system.

22. A layer system according to one of the preceding claims, **characterised in that** at least one further layer is arranged between the substrate and the first layer and/or between the first layer and the second layer of at least one partial layer system or of the layer system and/or where appropriate between at least two partial layer systems

23. A layer system according to the preceding claim, **characterised in that** the further layer is an adhesion-promoting layer and/or a barrier to diffusion.

24. A layer system according to one of the preceding claims, **characterised in that** at least one further layer which is protective against chemical and/or mechanical attack or damage is arranged on the second layer and/or on the topmost layer.

25. A method for the manufacture of a layer system according to one of the preceding claims, wherein a first layer which contains or comprises a photocatalytic material having photo-inducible hydrophilicity is applied to a substrate, and there is applied to the first layer a second layer comprising or containing diamond-like carbon (DLC) and having a hydrophobic surface which is remote from the first layer, **characterised in that** there is applied to the second layer, at least once, a further layer corresponding to the first layer or having a structure like that of the first layer, and there is applied to the latter a further layer corresponding to the second layer or having a structure like that of the second layer.

26. A method according to the preceding claim, **characterised in that** the first layer is applied by means of PVD, ion beam sputtering, magnetron sputtering, CVD, PECVD, vapour deposition, coating and/or sol-gel methods.

27. A method according to one of the two preceding claims, **characterised in that** the second layer is applied by means of PVD, ion beam sputtering, magnetron sputtering, CVD, PECVD, vapour deposition, coating and/or sol-gel methods.

28. A method according to one of Claims 25 to 27, **characterised in that** a further layer is applied between the substrate and the first layer and/or between the first layer and the second layer.

29. A method according to the preceding claim, **characterised in that**, as the further layer, a layer which is adhesion-promoting and/or a barrier to diffusion is applied.

30. A method according to one of the two preceding claims, **characterised in that** the further layer is applied by means of PVD, ion beam sputtering, magnetron sputtering, CVD, PECVD, vapour deposition, coating and/or sol-gel methods.

31. A method according to one of Claims 25 to 30, **characterised in that** the layer system is tempered.

32. A method according to the preceding claim, **characterised in that** the layer system is tempered at a temperature of between 200°C and 1000°C, preferably between 250°C and 800°C, preferably between 300°C and 600°C.

33. A method according to one of the two preceding claims, **characterised in that** the layer system is tempered for ≥ 1 min, preferably for ≥ 1 hour, preferably for ≥ 3 hours.

34. Use of a layer system and/or a method according to one of the preceding claims for coating glasses, ceramic, stoneware, brick tile and plastics as the substrate, for spectacle glasses, automotive windscreens, automotive illumination means, window panes, tiles, sanitary ware and/or roof tiles.

35. Use of a layer system and/or a method according to one of Claims 1 to 33 in printing technology, research and analytical work, in particular in biochip readers, for coating condensers in air conditioning systems and/or for coating display elements and/or sensor covers.

## Revendications

1. Système de couches photocatalytique comprenant un substrat et une première couche agencée sur le substrat et qui contient un matériau photocatalytique ayant une énergie de surface photo-inductible élevée, une bonne mouillabilité respectivement une bonne hydrophilie ou en est constituée, dans lequel une seconde couche ayant une surface médiocrement mouillable respectivement hydrophobe, opposée à la première couche, est agencée sur la première couche,
**caractérisé en ce que**,
sur le substrat, la première couche et la seconde couche forment une premier système de couches partiel, sur lequel est agencé au moins un autre second système de couches partiel, lequel présente une première couche correspondant à la première couche du premier système de couches partiel et, agencée par-dessus, une seconde couche correspondant à la seconde couche du premier système de couches partiel, de sorte que la première couche du second système de couches partiel est agencée sur la seconde couche du premier système de couches partiel situé en dessous.

2. Système de couches selon la revendication précédente, **caractérisé en ce que** le matériau ayant une hydrophilie photo-inductible contient un matériau semi-conducteur ou en est constitué.

3. Système de couches selon l'une quelconque des deux revendications précédentes, **caractérisé en ce que** le matériau ayant une hydrophilie photo-inductible contient un oxyde binaire, ternaire ou quaternaire ou en est constitué.

4. Système de couches selon la revendication précédente, **caractérisé en ce que** le matériau ayant une hydrophilie photo-inductible contient, individuellement ou sous forme d'un mélange, l'un des composés suivants : TiOₓ, ZnOₓ, WOₓ, SrTiOₓ, ZrOₓ, FeOₓ, NbOₓ, HfOₓ, SnOₓ, CeOₓ, AlOₓ, SiOₓ, BiOₓ, ou en est constitué.

5. Système de couches selon la revendication précédente, **caractérisé en ce que** le matériau ayant une hydrophilie photo-inductible contient, individuellement ou sous forme d'un mélange, l'un des composés suivants : TiO₂, SrTiO, ZrO₂, Fe₂O₃, SnO₂, ZnO, ou en est constitué.

6. Système de couches selon l'une quelconque des revendications précédentes, **caractérisé en ce que** le matériau ayant une hydrophilie photo-inductible est dopé avec d'autres matériaux, en particulier des métaux de transition et/ou les éléments Mo, Ca, S, C, F, Wo, B, N, Y, Nb, Si, Al, V, Cr, Sn, Ag, Ta, C, Pt, P, Cu et/ou Os.

7. Système de couches selon l'une quelconque des revendications précédentes, **caractérisé en ce que** la première couche présente une épaisseur ≥ 1 nm, avantageusement ≥ 10 nm.

8. Système de couches selon l'une quelconque des revendications précédentes, **caractérisé en ce que** la première couche présente une épaisseur ≤ 5 mm, avantageusement ≤ 1000 nm, plus avantageusement ≤ 500 nm.

9. Système de couches selon l'une quelconque des revendications précédentes, **caractérisé en ce que** la seconde couche est une couche de PTFE.

10. système de couches selon l'une quelconque des revendications 1 à 8, **caractérisé en ce que** la seconde couche est une couche constituée de carbone amorphe (DLC) ou contenant celui-ci.

11. Système de couches selon les revendications 1 à 8 ou 10, **caractérisé en ce que** la seconde couche est une couche de type a-C:H.

12. Système de couches selon l'une quelconque des deux revendications précédentes, **caractérisé en ce que** la seconde couche de DLC est pourvue par dopage d'une surface hydrophobe.

13. Système de couches selon l'une quelconque des trois revendications précédentes, **caractérisé en ce que** la seconde couche est dopé avec l'élément Si, O et/ou F.

14. Système de couches selon la revendication précédente, **caractérisé en ce que** la seconde couche est une couche de type a-C:H:Si:O, une couche de type a-C:-H:Si ou une couche de type a-C:H:F.

15. Système de couches selon l'une quelconque des revendications précédentes, **caractérisé en ce que** la seconde couche présente une épaisseur ≥ 1 nm, avantageusement ≥ 3 nm.

16. Système de couches selon l'une quelconque des revendications précédentes, **caractérisé en ce que** la seconde couche présente une épaisseur ≤ 200 nm, avantageusement ≤ 40 nm, plus avantageusement ≤ 20 nm.

17. Système de couches selon l'une quelconque des revendications précédentes, **caractérisé en ce que** le substrat contient, ne serait-ce qu'à sa surface, du verre, du métal, de la céramique, un matériau synthétique, du papier et/ou du cuir, ou en est constitué.

18. Système de couches selon l'une quelconque des revendications précédentes, **caractérisé en ce qu'**on agence sur le système de couches entre un et 1000, de préférence entre 10 et 100 autres systèmes de couches partiel, lesquels présentent respectivement une première couche correspondant à la première couche du premier système de couches partiel et, agencée par-dessus, une seconde couche correspondant à la seconde couche du premier système de couches partiel, de sorte que la première couche d'un système de couches partiel repose sur la seconde couche du système de couches partiel situé en dessous.

19. Système de couches selon l'une quelconque des revendications précédentes, **caractérisé en ce que** les premières couches et/ou les secondes couches présentent respectivement une épaisseur ≥ 2 nm.

20. Système de couches selon l'une quelconque des revendications précédentes, **caractérisé en ce que** les premières couches et/ou les secondes couches présentent respectivement une épaisseur ≤ 100 nm.

21. Système de couches selon l'une quelconque des revendications précédentes, **caractérisé en ce que** les premières couches d'une partie ou de la totalité des systèmes de couches partiels sont structurées comme la première couche du premier système de couches partiel et/ou **en ce que** les secondes couches d'une partie ou de la totalité des systèmes de couches partiels sont structurées comme la seconde couche du premier système de couches partiel.

22. Système de couches selon l'une quelconque des revendications précédentes, **caractérisé en ce qu'**au moins une autre couche est agencée entre le substrat et la première couche et/ou entre la première couche et la seconde couche d'au moins un système de couches partiel respectivement du système de couches et/ou le cas échéant entre au moins deux systèmes de couches partiels.

23. Système de couches selon la revendication précédente, **caractérisé en ce que** l'autre couche suivante est une couche adhésive et/ou une barrière de diffusion.

24. Système de couches selon l'une quelconque des revendications précédentes, **caractérisé en ce qu'**au moins une autre couche de protection contre les attaques ou les dégradations chimiques et/ou mécaniques est agencée sur la seconde couche et/ou sur la couche supérieure.

25. Procédé de fabrication d'un système de couches selon l'une quelconque des revendications précédentes, dans lequel on applique sur un substrat une première couche qui contient un matériau photocatalytique ayant une hydrophilie photo-inductible ou en est constitué, et par-dessus la première couche une seconde couche constituée de carbone amorphe (DLC) ou contenant celui-ci, ayant une surface hydrophobe opposée à la première couche, ,
**caractérisé en ce que**
l'on applique sur la seconde couche, au moins une fois, une autre couche correspondant à la première couche ou structurée comme la première couche et, par-dessus celle-ci, une autre couche correspondant à la seconde couche ou structurée comme la seconde couche.

26. Procédé selon la revendication précédente, **caractérisé en ce que** la première couche est appliquée par dépôt physique en phase vapeur (PVD), pulvérisation par faisceau d'ions, pulvérisation magnétron, dépôt chimique en phase vapeur (CVD), dépôt chimique en phase vapeur assisté par plasma (PECVD), évaporation, vernissage et/ou procédé sol-gel.

27. Procédé selon l'une quelconque des revendications précédentes, **caractérisé en ce que** la seconde couche est appliquée par PVD, pulvérisation par faisceau d'ions, pulvérisation magnétron, CVD, PECVD, évaporation, vernissage et/ou procédé sol-gel.

28. Procédé selon l'une quelconque des revendications 25 à 27, **caractérisé en ce qu'**une autre couche est appliquée entre le substrat et la première couche et/ou entre la première couche et la seconde couche.

29. Procédé selon la revendication précédente, **caractérisé en ce qu'**on applique une couche adhésive et/ou une couche barrière de diffusion pour servir d'autre couche.

30. Procédé selon l'une quelconque des revendications précédentes, **caractérisé en ce que** l'autre couche est appliquée par PVD, pulvérisation à faisceau d'ions, pulvérisation magnétron, CVD, PECVD, évaporation, vernissage et/ou procédé sol-gel.

31. Procédé selon l'une quelconque des revendications 25 à 30, **caractérisé en ce que** le système de couches est recuit.

32. Procédé selon la revendication précédente, **caractérisé en ce que** le système de couches est recuit à une température comprise entre 200 °C et 1000 °C, de préférence entre 250 °C et 800 °C, mieux encore entre 300 °C et 600 °C.

33. Procédé selon l'une quelconque des revendications précédentes, **caractérisé en ce que** le système de couches est recuit pendant une durée ≥ 1 min, de préférence ≥ 1 heure, mieux encore ≥ 3 heures.

34. Utilisation d'un système de couches et/ou d'un procédé selon l'une quelconque des revendications précédentes pour le revêtement de verres, de céramique, de faïence, de briques et de matériaux synthétiques en tant que substrat, de verres de lunettes, de vitres d'automobiles, d'éclairage d'automobiles, de vitres de fenêtres, de carrelage, d'articles sanitaires et/ou de tuiles.

35. Utilisation d'un système de couches et/ou d'un procédé selon l'une quelconque des revendications 1 à 33 en technique d'impression, en recherche et analyse, en particulier dans des lecteurs de biopuces, en revêtement de condensateurs dans des systèmes d'air conditionné et/ou en revêtement d'éléments d'affichage et/ou de recouvrements de capteurs.
